# EUROPEAN PATENT APPLICATION

(11) **EP 1 369 932 A2**
(43) Date of publication of application: **10.12.2003**
(21) Application number: 03011772.5
(22) Date of filing: 23.05.2003
(51) Int. Cl.: H01L 31/068, H01L 31/075, H01L 31/052, H01L 31/0392

(54) **Stacked photovoltaic element**

(30) Priority: 27.05.2002 JP 2002151757
(71) Applicant: CANON KABUSHIKI KAISHA, Tokyo 146 (JP)
(72) Inventor: Okada, Naoto, Ohta-ku, Tokyo (JP)
(74) Representative: Leson, Thomas Johannes Alois, Dipl.-Ing.

(57) **Abstract**

There is provided a photovoltaic element capable of efficiently collecting energy over the whole wavelength region of an incident light and having a high conversion efficiency, which comprises at least a first photovoltaic element 105 and a second photovoltaic element 103 stacked in the mentioned order from a light incidence side and a selectively reflective layer 104 provided between the first and the second photovoltaic elements so as to electrically connect the first and the second photovoltaic elements to each other in series and constructed such that a light having a wavelength within a range of λm ± 100 nm (λm being defined as such a wavelength as to maximize the spectral characteristics of the second photovoltaic element 103) resonates in the first photovoltaic element 105.

## Description

### BACKGROUND OF THE INVENTION

### Field of the Invention

The present invention relates to a stacked photovoltaic element having at least two power generating function units.

### Related Background Art

The photovoltaic elements are devices for converting an incident light energy to an electric energy, among which the solar cell is a photovoltaic element for converting the sunlight which is a white light to an electric energy and capable of efficient conversion of lights of a wide wavelength region. Therefore, in order to achieve a high conversion efficiency, it is necessary to make good use of lights over the whole range of a wide wavelength region efficiently. As a means for attaining this object, there is well known the stacked photovoltaic element formed by stacking elements having semiconductor layers of different band gaps as photoactivation layers. The stacked photovoltaic element efficiently absorbs and utilizes a light in a wide wavelength region by disposing an element using a semiconductor of a relatively large band gap at a light incidence side to absorb a short-wavelength light having a large energy and disposing an element using a semiconductor of a relatively small band gap under the light incidence side element to absorb a long-wavelength light having a small energy that has passed through the upper element.

In this case, it is necessary to introduce into each photovoltaic element a light of a wavelength region suitable for that element. This is because the wavelength region of an incident light that can be utilized by each photovoltaic element is limited by the band gap of a semiconductor used for a photoactivation layer of that photovoltaic element. That is, a photon having an energy smaller than a band gap energy is not absorbed by a semiconductor and can not be utilized. Moreover, although a photon having an energy greater than a band gap energy is absorbed by a semiconductor, the potential energy of an electron which can be provided when exciting the electron is limited to the magnitude of the band gap, so that it is impossible to use a difference component between the band gap energy and the photon energy. That is, in the case of the stacked photovoltaic element, it is important to make only a light of a short-wavelength region incident on the light incidence side element of a stacked photovoltaic element and to make only a light in a long-wavelength region incident on the underlying element.

As one of means for attaining this object, there is known a method of providing a transparent conductive film between upper and lower photovoltaic elements and using the film as a reflective layer.
For example, Japanese Patent Application Laid-Open No. 63-77167 discloses a method of providing a conductive layer as a selectively reflective layer for reflecting a short-wavelength light and passing a long-wavelength light therethrough between photovoltaic elements. Moreover, Japanese Patent Application Laid-Open No. 2-237172 discloses a method of adjusting the film thickness of the selectively reflective layer to conform the peak of the reflectance of the layer to a maximum wavelength of the spectral sensitivity of a light incidence side photovoltaic element, thereby increasing the current value of the light incidence side photovoltaic element. The both methods purpose to prevent a short-wavelength light to be originally absorbed by a light incidence side photovoltaic element from being absorbed by an underlying photovoltaic element to thereby improve the conversion efficiency of the light incident side photovoltaic element.

Because the current level of the improvement in the conversion efficiency of the photovoltaic element is very high, there is a requirement that even a small energy loss is not permitted. However, the above methods of providing a reflective layer still have a problem that a reflective layer slightly reflects a long-wavelength light, no matter what configuration the reflective layer is designed to have. The reflected long-wavelength light is not absorbed by the light incidence side element and may go out of the cell again or counteract an incident light, so that it is resultantly impossible to utilize the light. That is, the prior art has a problem that it is possible to improve the utilization efficiency of a short-wavelength light by selecting the wavelength of an incident light, which, however, lowers the utilization efficiency of a long-wavelength light on the contrary.

### SUMMARY OF THE INVENTION

It is, therefore, an object of the present invention to provide a photovoltaic element capable of efficiently collecting energy over the whole wavelength region of an incident light and having a high conversion efficiency.

The above object and others are accomplished in accordance with the present invention by providing a stacked photovoltaic element comprising at least a first photovoltaic element and a second photovoltaic element stacked in the mentioned order from a light incidence side and a selectively reflective layer provided between the first and the second photovoltaic elements so as to electrically connect the first and the second photovoltaic elements to each other in series and constructed such that a light having a wavelength within a range of λm ± 100 nm (λm being defined as such a wavelength as to maximize the spectral characteristics of the second photovoltaic element) resonates with the first photovoltaic element.

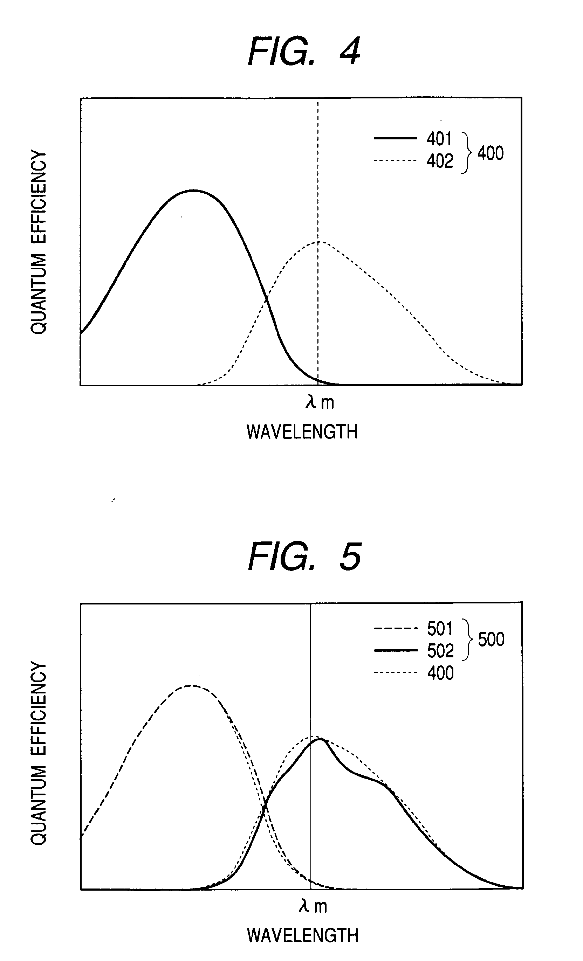

The symbol "λm" as herein employed refers to a wavelength at which the spectral characteristics of the second photovoltaic element become maximum, as described below with reference to FIG. 4.

In the present invention, it is preferable that the stacked photovoltaic element is constructed such that a light having a wavelength within a range of from (λm - 50 nm) to (λm + 100 nm) resonates with the first photovoltaic element.

Furthermore, it is preferable that the reflectance of the selectively reflective layer is high in a wavelength region shorter than λm and is low in a wavelength region longer than λm.

As the first photovoltaic element of the present invention, there is preferably used a photovoltaic element comprising a pin-type junction in which the i-type layer comprises amorphous Si:H.

Moreover, as the second photovoltaic element of the present invention, there is preferably used a photovoltaic element comprising a pin-type junction in which the i-type layer comprises microcrystalline Si.

Furthermore, as the second photovoltaic element of the present invention, there is also preferably used a photovoltaic element comprising a pin-type junction in which the p-type and n-type semiconductors each comprise monocrystalline or polycrystalline Si.

### BRIEF DESCRIPTION OF THE DRAWINGS

FIG. 1 is a schematic view illustrating a sectional structure of an embodiment of the stacked photovoltaic element of the present invention;
FIG. 2 is a schematic view illustrating a sectional structure of another embodiment of the stacked photovoltaic element of the present invention;
FIG. 3 is a schematic view illustrating a sectional structure of a stacked photovoltaic element having no selectively reflective layer;
FIG. 4 is a spectral diagram showing the spectral sensitivity characteristics of a stacked photovoltaic element having no selectively reflective layer;
FIG. 5 is a graphical representation for comparing a spectrum showing the spectral sensitivity characteristics of a stacked photovoltaic element of the present invention with a spectrum showing the spectral sensitivity characteristics of a stacked photovoltaic element having no selectively reflective layer;
FIG. 6 is a schematic view illustrating an embodiment of an apparatus suitable for forming a semiconductor layer of a stacked photovoltaic element of the present invention; and
FIG. 7 is a graphical representation showing a relation between the ratio in conversion efficiency of Example to Comparative Example (Example/Comparative Example) and λm - λp.

### DESCRIPTION OF THE PREFERRED EMBODIMENTS

Embodiments of the stacked photovoltaic element of the present invention are described below. However, the present invention is no way limited to the embodiments.

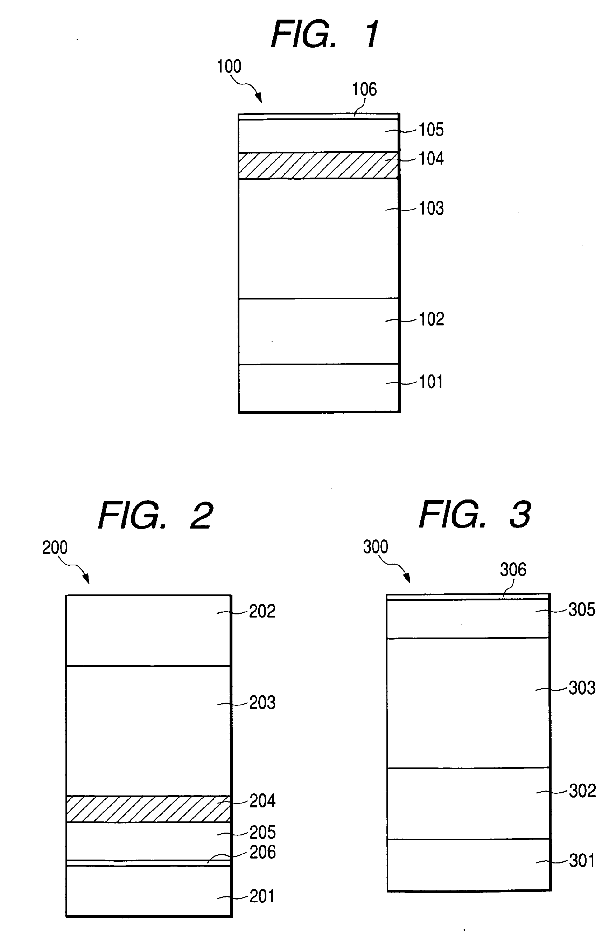

FIG. 1 is a schematic view illustrating a sectional structure of a stacked photovoltaic element 100 in accordance with an embodiment of the present invention. A light reflective layer 102, a second photovoltaic element 103, a selectively reflective layer 104, a first photovoltaic element 105 and a transparent electrode 106 are stacked in the mentioned order on a conductive substrate 101 made of a metal or the like.

The semiconductors constituting photoactivation portions of the first photovoltaic element 105 and the second photovoltaic element 103 are such that the semiconductor of the first photovoltaic element 105 has a band gap greater than that of the semiconductor of the second photovoltaic element 103 and designed so that a light of a short-wavelength region is absorbed by the first photovoltaic element 105 and a light of a long-wavelength region is absorbed by the second photovoltaic element 103.

The selectively reflective layer 104 has a high reflectance in the above mentioned short-wavelength region and exhibits an effect of increasing the quantity of light to be absorbed by the first photovoltaic element 105.

FIG. 2 is a schematic view illustrating a sectional structure of a stacked photovoltaic element 200 in accordance with another embodiment of the present invention. A transparent electrode 206, a first photovoltaic element 205, a selectively reflective layer 204, a second photovoltaic element 203 and a conductive light-reflective layer 202 are stacked in the mentioned order on a substrate 201 made of a. light transmissive insulating plate such as of glass or the like. In this case, a light is made incident on the element from the side of the substrate 201 which is a light transmissive insulating plate.

FIG. 3 is a schematic view illustrating the sectional structure of a stacked photovoltaic element 300 having the same configuration as the stacked photovoltaic element 100 of the present invention with the exception that a layer corresponding to the selectively reflective layer 104 is not provided. A light reflective layer 302, a second photovoltaic element 303, a first photovoltaic element 305, and a transparent electrode 306 are stacked in the mentioned order on a conductive substrate 301 made of a metal or the like.

FIG. 4 shows the spectral sensitivity characteristics of the stacked photovoltaic element 300, in which the axis of abscissa denotes a wavelength and the axis of ordinate denotes a quantum efficiency. The term "quantum efficiency" herein employed is intended to mean the ratio of the number of electrons which can be collected outside the element to the number of photons incident on the element. A spectral-sensitivity spectrum 400 can be divided into the spectral-sensitivity spectrum 401 of the first photovoltaic element 305 and the spectral-sensitivity spectrum 402 of the second photovoltaic element 303.

First, the power-generation action of the stacked photovoltaic element 300 will be described with reference to FIGS. 3 and 4. Substantially all of a light having a relatively short wavelength of the light incident through the transparent electrode 306 is absorbed by the first photovoltaic element 305 having a wide band gap to generate carriers. Therefore, the light having a short wavelength does not reach the second photovoltaic element 303, so that as shown by reference numeral 402, the second photovoltaic element 303 does not show a sensitivity in a short-wavelength region. On the other hand, because substantially all of a light in a long-wavelength region is not absorbed by the first photovoltaic element 305 to pass through the first photovoltaic element 305, no carrier is generated and as shown by reference numeral 401, the first photovoltaic element 305 does not show a spectral sensitivity in a long-wavelength region at all.

However, there is a middle region between the both regions, in which the first photovoltaic element 305 and the second photovoltaic element 303 both show a spectral sensitivity. In this region, a light which cannot be absorbed by the first photovoltaic element 305 "directly (or as such)" enters the second photovoltaic element 303. The entering light has an energy enough to be absorbed and all of the entering light is absorbed. Because carriers are then generated by the absorbed light, the spectral sensitivity spectrum 402 of the second photovoltaic element 303 becomes steep as shown in FIG. 4.

The second photovoltaic element 303, when used alone, originally shows a high spectral sensitivity also in a short-wavelength region. However, because the spectral sensitivity spectrum 402 of the second photovoltaic element 303 of the stacked photovoltaic element 300 will take a shape in which a portion of a short-wavelength region is cut out because all of a light in a short-wavelength region is absorbed by the first photovoltaic element 305. Therefore, the spectral sensitivity spectrum 402 of the second photovoltaic element 303 shows a maximum spectral sensitivity at a wavelength λm close to a wavelength at which the spectral sensitivity spectrum 401 of the first photovoltaic element 305 becomes 0. Incidentally, the term "a wavelength at which the spectral characteristics of the second photovoltaic element become maximum" employed herein denotes the wavelength λm.

Then, the power-generation action of the stacked photovoltaic element 100 of the present invention is described below. Here, FIG. 5 shows a comparison between the spectral sensitivity spectrum 500 of the stacked photovoltaic element 100 of the present invention and the spectral sensitivity spectrum 400 of the stacked photovoltaic element 300 not provided with the selectively reflective layer 104. A spectral sensitivity spectrum 501 is the spectral sensitivity spectrum of the first photovoltaic element 105 and a spectral sensitivity spectrum 502 is the spectral sensitivity spectrum of the second photovoltaic element 103 of the present invention.

As is the case with the stacked photovoltaic element 300, substantially all of a light having a relatively short wavelength of the light incident through the transparent electrode 106 is absorbed by the first photovoltaic element 105 having a wide band gap. A light having a longer wavelength reaches the selectively reflective layer 104 because of its low absorptance. The incident light is reflected here and returns to the first photovoltaic element 105 again to be absorbed there. Therefore, the spectral sensitivity spectrum 501 has a high sensitivity at a long-wavelength portion as compared to that of the spectral sensitivity spectrum 401 and resultantly, the first photovoltaic element 105 can provide a greater current. When the wavelength becomes longer and reaches a value close to λm, the light reflected by the selectively reflective layer 104 reaches the transparent electrode 106 and is reflected by the electrode 106 again and starts to interfere with a directly incident light in the first photovoltaic element 105.

In this case, because the optical constants such as film thickness, refractive index, and the like of the first photovoltaic element 105 of the present invention are set so as to cause an optical resonance at a wavelength in the vicinity of λm, the incident light and the reflected light will not counteract each other in the first photovoltaic element 105. The light thus strengthened in the first photovoltaic element 105 is thereafter led to the second photovoltaic element 103 and absorbed by the second photovoltaic element 103. Therefore, in the case of the spectral sensitivity spectrum 502, it is possible to confirm a peak due to interference at a wavelength nearby λm and it is seen that the wavelength of the peak is a wavelength at which the optical resonance is occurred in the first photovoltaic element 105.

In this connection, because the reflected light is hardly absorbed by the first photovoltaic element 105, if an optical resonance does not occur in the first photovoltaic element 105, the incident light and the reflected light will counteract each other to lose the optical energy.

Because the reflectance of the selectively reflective layer 104 decreases in a longer wavelength region, the light directly enters the second photovoltaic element 103, so that substantially all of the light is absorbed by the second photovoltaic element 103.

Thus, the stacked photovoltaic element of the present invention effectively absorbs lights over the whole wavelength region to exhibit a high energy utilization efficiency, with the result that a high conversion efficiency can be realized.

Then, the components of the element of the present invention are described below.

### (Substrate)

As a substrate for use in the stacked photovoltaic element of the present invention, it is suitable to use a conductive substrate such as a metal plate, for example, a stainless steel plate or an insulating substrate as made conductive by depositing a metal or the like. Ferrite-based stainless steel is preferably used as the metal substrate and glass, ceramics or polyimide is preferably used as the insulating substrate. Further, when a light is made incident from the substrate side, a light transmissive insulating substrate is used, particularly glass is preferably used.

### (Reflective layer)

As the reflective layer for the stacked photovoltaic element of the present invention, there is used a deposited film of a metal such as Al, Ag, Au, Cu, etc. or an alloy thereof. Moreover, it is preferable that the surface of the reflective layer has such an unevenness as to cause irregular reflections. A preferable range of the thickness of the reflective layer is 10 nm to several µm.
Moreover, it is preferable to provide a reflection enhancing layer for the reflective layer in order to increase the quantity of reflected light.

A metal oxide such as indium oxide, tin oxide or zinc oxide is suitable as the material for the reflection enhancing layer. A preferable range of the thickness of the reflection enhancing layer is 100-5000 nm.

### (Second photovoltaic element)

Examples of the junction of the second photovoltaic element used for the stacked photovoltaic element of the present invention include a pn junction, pin junction, MIS junction, or the like. Moreover, the semiconductor used for the photoactivation layer includes a monocrystalline, polycrystalline, microcrystalline, or amorphous material of Group IV, III-V, II-VI or I-III-VI₂. The Group IV material includes Si, Ge and an alloy thereof, the Group III-V material includes GaAs, GaSb, InP, and InAs, the Group II-VI material includes CdTe and Cu₂S and the Group I-III-VI₂ material includes CuInSe₂ and so on. Particularly, pn-type monocrystalline Si, pn-type polycrystalline Si or pin-type amorphous SiGe:H is preferably used. Pin-type microcrystalline Si is more preferably used. Moreover, in the case of the non-monocrystalline material, it is preferable that the p-layer and n-layer are microcrystalline.

### (Selectively reflective layer)

As the selectively reflective layer for the stacked photovoltaic element of the present invention, there is preferably used indium oxide, tin oxide, indium-tin oxide or zinc oxide (ZnO). Particularly, zinc oxide (ZnO) is preferably used and the selectively reflective layer can be formed by the sputtering method, vacuum evaporation method, chemical vapor deposition method, ion plating method, ion beam method, ion beam sputtering method, or the like. Moreover, it is possible to form the selectively reflective layer also by electrodeposition or dipping using an aqueous solution containing nitrate, acetate or ammonium ions, and metal ions.

Moreover, it is preferable that the reflectance at an interface between the selectively reflective layer and the first photovoltaic element varies so as to be high in a wavelength region shorter than λm and to be low in a wavelength region longer than λm, on the basis of the wavelength λm.

Furthermore, it is preferable that the refractive index of the selectively reflective layer is lower than the refractive index of a portion in contact with the selectively reflective layer of the first photovoltaic element, in order to raise the reflectance.

### (First photovoltaic element)

Examples of the junction of the first photovoltaic element used for the stacked photovoltaic element of the present invention include a pn junction, pin junction, MIS junction, or the like. Moreover, the semiconductor used for the photoactivation layer includes a monocrystalline, polycrystalline, microcrystalline, or amorphous material of Group IV, III-V or II-VI. The Group IV material includes Si, Ge, C and an alloy thereof, the Group III-V material includes AlAs, AlSb, GaN, GaP, GaAs, and InP, the Group II-VI material includes ZnSe, ZnS, ZnTe, CdS, CdSe, and so on. Preferably, pin-type amorphous Si:H is used. Moreover, it is preferable that the p-layer and n-layer are microcrystalline.

Furthermore, the refractive index n and film thickness d of the first photovoltaic element at a wavelength within the range of λm ± 100 nm are set such that the product nd satisfies the relation 2Nλm=nd (N is an optional integer) in order to make sure that the light having a wavelength of λm ± 100 nm, at which the spectral characteristics of the second photovoltaic element become maximum, resonates. Particularly, in the case of pin-type amorphous Si:H element, it is preferable to set the refractive index n within a range of 3.0-4.5 and the film thickness d of the element within a range of 100-900 nm under the conditions that the relation 2Nλm=nd is satisfied.
It is more preferable to set the refractive index n within a range of 3.5-4.0 and the film thickness d of the element within a range of 300-700 nm.

### (Transparent electrode)

The material of the transparent electrode used for the stacked photovoltaic element of the present invention includes indium oxide, tin oxide or indium-tin oxide and the transparent electrode is formed by the sputtering method, vacuum evaporation method, chemical vapor deposition method, ion plating method, ion beam method, ion beam sputtering method, or the like. Moreover, it is possible to form the transparent electrode also by electrodeposition or dipping using an aqueous solution containing nitrate, acetate or ammonium ions, and metal ions.

### (Examples)

Preferred examples of the present invention are described below in detail by referring to the accompanying drawings. However, the present invention is no way limited to the examples.

### (Example 1)

A stacked photovoltaic element of the configuration shown in FIG. 1 was prepared using a pin-type photovoltaic element whose i-layer is intrinsic amorphous Si:H as a first photovoltaic element, a pin-type photovoltaic element whose i-layer is intrinsic microcrystalline Si as a second photovoltaic element and zinc oxide (ZnO) as a selectively reflective layer.

As a substrate 101, a flat stainless steel sheet (SUS430) subjected to the so-called BA finishing of 45 mm square and 0.15 mm in thickness was used and set in a commercially available DC magnetron sputtering system (not illustrated), and the system was exhausted until the inner pressure became 10⁻³ Pa or less.

Thereafter, argon gas was supplied into the system at 30 sccm (sccm represents a unit of flow rate and 1 sccm = 1 cm³/min (standard conditions)) and the inner pressure was kept at 2×10⁻¹ Pa. The substrate was not heated and a DC power of 120 W was applied to an aluminum target of 6 inch φ to form an aluminum thin film of a thickness of 70 nm for 90 seconds.

Then, the substrate was heated up to 300°C, electrical connection was changed to a zinc oxide target of 6 inch φ, and a DC power of 500 W was applied for 30 minutes to deposit a zinc oxide (ZnO) reflection enhancing film of about 3,000 nm in thickness, thus completing the substrate 101.

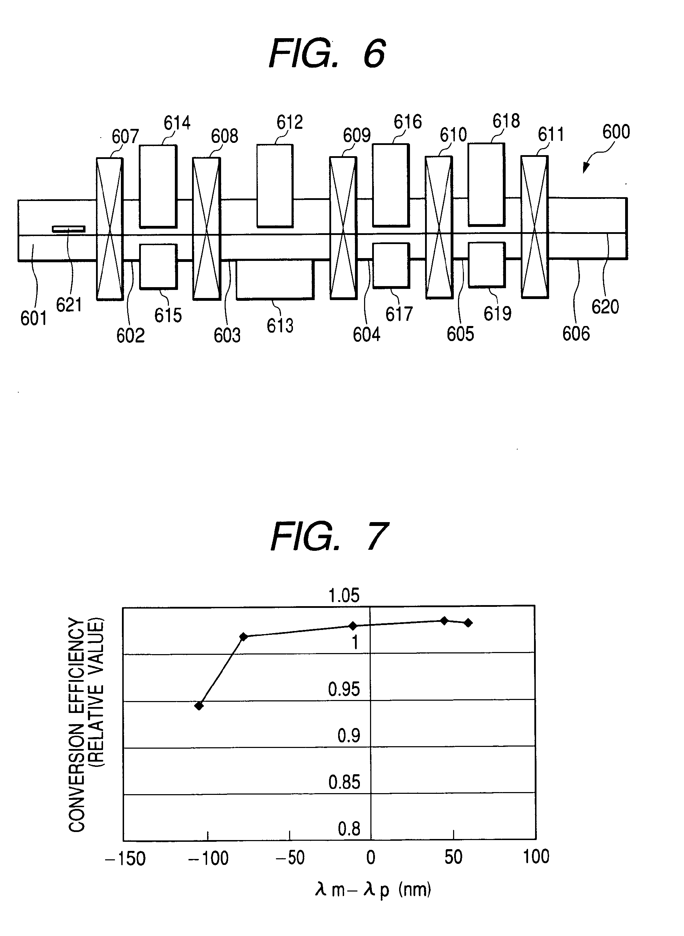

FIG. 6 is a schematic view showing a configuration of a system suitable for forming a semiconductor layer of the stacked photovoltaic element of the present invention. In FIG. 6, a deposited film forming system 600 is mainly constituted by a loading chamber 601, a microcrystalline silicon i-type layer chamber 603, an amorphous silicon i-type layer RF chamber 604, an n-type layer RF chamber 602, a p-type layer RF chamber 605 and an unloading chamber 606. The chambers are isolated from each other by gate valves 607, 608, 609, 610 and 611 so that source gases are not mixed with each other.

The microcrystalline silicon i-type layer chamber 603 is constituted by a heater 612 for heating a substrate and a plasma CVD chamber 613.
The RF chamber 602 has a heater 614 for n-type layer deposition and a deposition chamber 615 for n-type layer deposition; the RF chamber 604 has a heater 616 for i-type layer deposition and a deposition chamber 617 for i-type layer deposition; and the RF chamber 605 has a heater 618 for p-type layer deposition and a deposition chamber 619 for p-type layer deposition.

The substrate is set to a substrate holder 621 and moved on a rail 620 by externally driven rollers. In the plasma CVD chamber 613 is deposited a microcrystalline film. The microwave plasma CVD method or VHF plasma CVD method is used for the deposition of a microcrystalline film.

The deposited film forming system was used to form semiconductor layers under the predetermined film forming conditions for respective layers shown in Table 1. In this case, four samples were prepared by changing the thicknesses of the amorphous Si:H i-type layer of the first photovoltaic element as shown in Table 2.

**Table 1**

| | | Film forming gas and flow rates (sccm) | | | | Power density (W/cm²) | | Pressure (Pa) | Substrate temperature (°C) | Film thickness (nm) |
|---|---|---|---|---|---|---|---|---|---|---|
| | | SiH₄ | H₂ | PH₃ (2%H dilution) | BF₃ (2%H dilution) | RF | VHF | | | |
| First photo-voltaic element | n1 | 2 | 48 | 0.5 | | 0.04 | | 180 | 225 | 10 |
| | i1 | 2 | 48 | | | 0.04 | | 150 | 210 | - |
| | p1 | 0.025 | 35 | | 1 | 1.2 | | 270 | 165 | 5 |
| Second photo-voltaic element | n2 | 2 | 48 | 0.5 | | 0.04 | | 180 | 225 | 20 |
| | i2 | 25 | 750 | | | | 0.2 | 40 | 250 | 2000 |
| | p2 | 0.025 | 35 | | 1 | 1.2 | | 270 | 165 | 5 |

**Table 2**

| Sample No. | i-layer thickness (nm) |
|---|---|
| Example a | 460 |
| Example b | 480 |
| Example c | 500 |
| Example d | 520 |

First, the second photovoltaic element 103 was formed on the substrate 101 by the following procedure in accordance with Table 1.

The substrate 101 was set to the substrate holder 621, which was set on the rail 620 of the loading chamber 601. Then, the inside of the loading chamber 601 was exhausted to a vacuum of several hundred mPa or less.

Then, the gate valve 607 was opened and the substrate holder 621 was moved to the n-type layer deposition chamber 615 of the chamber 602. In a state that the gate valves 607, 608, 609, 610 and 611 were closed, an n-type layer was deposited in the predetermined film thickness using the predetermined source gases.

Then, after sufficient exhaustion, the gate valve 608 was opened and the substrate holder 621 was moved to the deposition chamber 603 and the gate valve 608 was closed.

Then, the substrate was heated to the predetermined substrate temperature by the heater 612, the predetermined source gases were introduced at the predetermined flow rates, the predetermined microwave energy or VHF energy was introduced into the deposition chamber 613 at a predetermined vacuum degree to generate a plasma, thereby depositing a microcrystalline silicon i-type layer on the substrate in the predetermined thickness.

Then, after the chamber 603 was sufficiently exhausted, the gate valves 609 and 610 were opened and the substrate holder 621 was moved from the chamber 603 to the chamber 605.

After the substrate holder 621 was moved to the p-type layer deposition chamber 619 of the chamber 605, the substrate was heated to the predetermined temperature with the heater 618. The source gases for p-type layer deposition were supplied to the deposition chamber 619 at the predetermined flow rates and an RF energy was introduced into the deposition chamber 619 while keeping a predetermined vacuum degree to deposit a p-type layer in the predetermined thickness.

After the deposition chamber 619 was sufficiently exhausted flowing the above described procedure, the gate valve 611 was opened and the substrate holder 621 with the substrate 101 having the semiconductor layers deposited thereon was moved to the unloading chamber 606.

Then, after all the gate valves were closed, nitrogen gas was introduced into the unloading chamber 606 in a sealed state to lower the substrate temperature. Thereafter, a take-out valve of the unloading chamber 606 was opened and the substrate holder 621 was taken out.

Then, the substrate 101 on which the second photovoltaic element 103 was finally formed was detached from the substrate holder 621 and set to a commercially available DC magnetron sputtering system (not illustrated) in order to form the selectively reflective layer 104, and the system was exhausted until the inner pressure became 10⁻³ Pa or less.

Thereafter, argon gas was supplied at 300 sccm and the pressure was kept at 2×10⁻¹ Pa. Then, the substrate temperature was raised to 300°C, electrical connection was changed to a zinc oxide target of 6 inch φ, and a DC power of 500 W was applied to deposit a zinc oxide selectively reflective layer in a thickness of about 600 nm.

Then, using the deposited film forming system 600 again, a pin-type amorphous Si:H photovoltaic element was prepared as the first photovoltaic element 105 on the substrate 101 having the selectively reflective layer formed thereon, following the procedure described below.

An n-type layer was deposited in the predetermined thickness under the predetermined conditions following the procedure described above for the formation of the second photovoltaic element 103. After sufficient exhaustion, the gate valves 608 and 609 were opened and the substrate holder 621 was moved to the deposition chamber 604, and the gate valves 608 and 609 were closed.

Then, after the substrate was heated to the predetermined substrate temperature by the heater 616, the predetermined source gases were supplied at predetermined flow rates, the predetermined RF energy was introduced into the deposition chamber 617 at the predetermined vacuum degree to generate a plasma, thereby depositing an amorphous Si:H i-type layer on the substrate in the predetermined thickness by adjusting the formation time in accordance with Table 1. The chamber 604 was sufficiently exhausted and the gate valve 610 was opened to move the substrate holder 621 from the chamber 604 to the chamber 605.

Then, a p-type layer was deposited in the predetermined film thickness under the predetermined conditions following the procedure described above for the formation of the second photovoltaic element 103.

Then, after the deposition chamber 619 was sufficiently exhausted in the above described manner, the gate valve 611 was opened to move the substrate holder 621 with the substrate 101 having the semiconductor layers deposited thereon was moved to the unloading chamber 606.

Then, the substrate holder 621 was taken out from the unloading chamber 606 in the above described manner.

Then, the substrate 101 on which the semiconductor layers were deposited was detached from the substrate holder 621 and was attached to the surface of the anode of the DC magnetron sputtering system, the peripheral portion of the substrate was shielded with a stainless steel mask, and a target consisting of 10 wt% of tin oxide and 90 wt% of indium oxide was used to effect sputtering of indium-tin oxide as the transparent electrode 106 in a central region of 40 mm square of the substrate. The deposition conditions were the substrate temperature of 170°C, the flow rate of argon as an inert gas of 50 sccm, the flow rate of oxygen gas of 0.5 sccm, the pressure inside the deposition chamber of 300 mPa, the input electric power per unit area of the target of 0.2 W/cm² and the deposition was carried out such that the deposited film thickness became 70 nm for about 100 seconds. The film thickness was adjusted to a predetermined value by previously checking the relation between a deposited film thickness and a deposition time under the same conditions as described above and depositing the film utilizing the relation.

### (Comparative Example 1)

A sample of a stacked photovoltaic element of the same structure as the element of Example 1 was prepared following the same procedure as Example 1 with the exception that the thickness of the i-type layer of the first photovoltaic element was changed to 540 nm. The thus prepared sample was named "Comparative Example 1".

### (Comparative Example 2)

Five samples of stacked photovoltaic elements were prepared in which the thickness of the i-type layer of the first photovoltaic element was varied similarly to Example 1 following the same procedure as Example 1 with the exception that the step of forming a selectively reflective layer was omitted. Table 3 shows the relation between sample names given to the thus prepared five samples and thicknesses of i-type layers of the samples.

**Table 3**

| Sample Name | i-layer thickness (nm) |
|---|---|
| Comparative Example 2a | 460 |
| Comparative Example 2b | 480 |
| Comparative Example 2c | 500 |
| Comparative Example 2d | 520 |
| Comparative Example 2e | 540 |

The spectral sensitivities of the 10 samples prepared in Example 1, Comparative Example 1 and Comparative Example 2 were measured.

The spectral sensitivity characteristics were measured using model YQ-250BX produced by JASCO Corporation. The spectral sensitivity characteristics of the first and the second photovoltaic elements of each stacked photovoltaic element were measured as described below.

The spectral sensitivity characteristics of the first photovoltaic element were measured by applying to the stacked photovoltaic element a bias voltage equivalent to an electromotive force generated by the second photovoltaic element when irradiated with a light and further effecting irradiation with a bias light within a region of wavelength mainly absorbed by the second photovoltaic element, effecting irradiation with a monochromatic probing light and observing a current generated at that time.

Moreover, the spectral sensitivity characteristics of the second photovoltaic element were measured in a manner similar to that described for the measurement of the first photovoltaic element, by applying a bias voltage equivalent to an electromotive force of the first photovoltaic element and effecting irradiation with a bias light within a region of wavelength mainly absorbed by the first photovoltaic element.

For each of the four samples of Example 1 and the sample of Comparative Example 1, a small peak resulting from optical resonance was observed in the spectral sensitivity spectrum of the second photovoltaic element. Table 4 shows these peak wavelength λp and the wavelength λm at which the second photovoltaic elements of the five stacked photovoltaic element samples prepared in Comparative Example 2 show maximum sensitivity for each i-layer thickness.

**Table 4**

| i-layer thickness (nm) | λm | λp |
|---|---|---|
| 460 | 721 nm (Example a) | 660 nm (Comparative example 2a) |
| 480 | 726 nm (Example b) | 680 nm (Comparative example 2b) |
| 500 | 730 nm (Example c) | 740 nm (Comparative example 2c) |
| 520 | 733 nm (Example d) | 810 nm (Comparative example 2d) |
| 540 | 735 nm (Comparative Example 1) | 840 nm (Comparative example 2e) |

Moreover, the short circuit photocurrent of each photovoltaic element was calculated on the basis of the spectral sensitivity characteristics. The short circuit photocurrent value of the first photovoltaic element was calculated by convoluting the spectral intensity of the sunlight in the previously measured spectral sensitivity spectrum of the first photovoltaic element. The short circuit photocurrent value of the second photovoltaic element was calculated by convoluting the spectral intensity of the sunlight in the previously measured spectral sensitivity spectrum of the second photovoltaic element. Table 5 shows the above calculation results.

**Table 5**

| i-layer thickness (nm) | Sample name | First photo-voltaic element | Second photo-voltaic element | Sample name | First photo-voltaic element | Second photo-voltaic element |
|---|---|---|---|---|---|---|
| 460 | Example a | 11.75 | 12.60 | Comparative Example 2a | 11.98 | 12.39 |
| 480 | Example b | 11.89 | 12.47 | Comparative Example 2b | 12.13 | 12.29 |
| 500 | Example c | 12.05 | 12.33 | Comparative Example 2c | 12.21 | 12.24 |
| 520 | Example d | 12.20 | 12.17 | Comparative Example 2d | 12.29 | 12.09 |
| 540 | Comparative Example 1 | 12.30 | 12.07 | Comparative Example 2e | 12.41 | 11.95 |
| (Unit: mA/cm²) | | | | | | |

Then, the current-voltage characteristics of each sample were measured by model YSS-150 produced by Yamashita Denso Corporation under irradiation with a light of a spectrum of AMl.5 and an intensity of 100 mW/cm². The short circuit current density [Jsc (mA/cm²) ] and open circuit voltage [Voc(V)], fill factor [FF] and conversion efficiency [Eff.(%)] were determined from the measured current-voltage characteristics.

Table 6 shows the values of the characteristics for each i-layer thickness as the ratio of the values of Example to the values of Comparative Example (Example/Comparative Example). Further, the relation between the conversion efficiency [Eff.(%)] and λm-λp obtained from Table 6 is shown in the graphical representation of FIG. 7.

**Table 6**

| | Jsc | FF | Voc | Eff. | λₘ-λₚ | i-layer thickness |
|---|---|---|---|---|---|---|
| Example a/ Comparative Example 2a | 1.0144 | 0.9929 | 0.9993 | 1.0064 | 61 nm | 460 mn |
| Example b/ Comparative Example 2b | 1.0218 | 0.9957 | 0.9993 | 1.0167 | 46 nm | 480 nm |
| Example c/ Comparative Example 2c | 1.0199 | 1.0029 | 1.0007 | 1.0186 | -10 nm | 500 nm |
| Example d/ Comparative Example 2d | 1.0079 | 1.0000 | 1.0019 | 1.0089 | -77 nm | 520 nm |
| Comparative Example 1/ Comparative Example 2e | 1.0008 | 0.9985 | 0.9986 | 0.9979 | -105 nm | 540 nm |

It can be seen from Table 6 that in the case of the samples "Example a to Example d" of Example 1 as an element of a structure having an optical resonant wavelength within the range in accordance with the present invention, it is possible to realize high conversion efficiencies because the Jsc can be increased without lowering the fill factor. Moreover, it can be seen from Table 6 and the graph of FIG. 7 that in the case of the sample "Comparative Example 1" with a selectively reflective layer prepared in Comparative Example 1, because the resonant wavelength greatly deviates, the conversion efficiency is greatly lowered compared to the samples free from a selectively reflective layer.

As described above, according to the present invention, it is possible to provide a stacked photovoltaic element capable of realizing a high conversion efficiency because an incident light can be absorbed without loss over the whole wavelength region.

There is provided a photovoltaic element capable of efficiently collecting energy over the whole wavelength region of an incident light and having a high conversion efficiency, which comprises at least a first photovoltaic element 105 and a second photovoltaic element 103 stacked in the mentioned order from a light incidence side and a selectively reflective layer 104 provided between the first and the second photovoltaic elements so as to electrically connect the first and the second photovoltaic elements to each other in series and constructed such that a light having a wavelength within a range of λm ± 100 nm (λm being defined as such a wavelength as to maximize the spectral characteristics of the second photovoltaic element 103) resonates in the first photovoltaic element 105.

## Claims

1. A stacked photovoltaic element comprising at least a first photovoltaic element and a second photovoltaic element stacked in the mentioned order from a light incidence side and a selectively reflective layer provided between the first and the second photovoltaic elements so as to electrically connect the first and the second photovoltaic elements to each other in series and constructed such that a light having a wavelength within a range of λm ± 100 nm (λm being defined as such a wavelength as to maximize the spectral characteristics of the second photovoltaic element) resonates in the first photovoltaic element.

2. The stacked photovoltaic element according to claim 1, which is constructed such that a light having a wavelength within a range of from (λm - 50 nm) to (λm +100 nm) resonates in the first photovoltaic element.

3. The stacked photovoltaic element according to claim 1, wherein the reflectance of the selectively reflective layer is high in a wavelength region shorter than λm and is low in a wavelength region longer than λm.

4. The stacked photovoltaic element according to claim 3, wherein the first photovoltaic element comprises a pin-type junction in which the i-type layer comprises amorphous Si:H.

5. The stacked photovoltaic element according to claim 4, wherein the second photovoltaic element comprises a pin-type junction in which the i-type layer comprises microcrystalline Si.

6. The stacked photovoltaic element according to claim 4, wherein the second photovoltaic element comprises a pn-type junction in which the p-type and n-type semiconductors each comprise monocrystalline or polycrystalline Si.
